# EUROPEAN PATENT APPLICATION

(11) **EP 4 791 131 A1**
(43) Date of publication of application: **12.08.2026**
(21) Application number: 25216782.0
(22) Date of filing: 18.11.2025
(51) Int. Cl.: H05K 7/20, F02C 7/12, F02C 7/16, F02C 7/18, F02C 7/32, F02K 3/06

(54) **ELECTRIC MACHINE COOLING PLATE FOR AIRCRAFT POWERPLANT**

(30) Priority: 18.11.2024 US 202418951013
(71) Applicant: RTX Corporation, Farmington, CT 06032 (US)
(72) Inventor: CLARK, Thomas E., Wells (US); AKIN, John, Charlotte (US); BREAULT, Andrew E., Bolton (US)
(74) Representative: Dehns

(57) **Abstract**

An aircraft powerplant assembly includes a cooling plate (128), a first electric machine controller and a second electric machine controller. The cooling plate (128) includes a fluid cooling circuit (164), a cooling circuit inlet (166) and a cooling circuit outlet (168). The fluid cooling circuit (164) extends within the cooling plate (128) from the cooling circuit inlet (166) to the cooling circuit outlet (168). A first controller housing is removably attached to the cooling plate (128) and overlaps the fluid cooling circuit (164). First controller circuitry is in thermal communication with the cooling plate (128) through a wall of the first controller housing. A second controller housing is removably attached to the cooling plate (128) and overlaps the fluid cooling circuit (164). Second controller circuitry is in thermal communication with the cooling plate (128) through a wall of the second controller housing.

## Description

### BACKGROUND OF THE DISCLOSURE

### 1. Technical Field

This disclosure relates generally to an aircraft powerplant and, more particularly, to cooling electronics of the aircraft powerplant.

### 2. Background Information

An aircraft powerplant includes various electronics which may utilize heat dissipation during aircraft powerplant operation. Various heat dissipation systems and methods are known in the art. While these known heat dissipation systems and methods have various benefits, there is still room in the art for improvement.

### SUMMARY OF THE DISCLOSURE

According to an aspect of the present disclosure, an assembly is provided for an aircraft powerplant. This assembly includes a cooling plate, a first electric machine controller and a second electric machine controller. The cooling plate includes a fluid cooling circuit, a cooling circuit inlet and a cooling circuit outlet. The fluid cooling circuit extends within the cooling plate from the cooling circuit inlet to the cooling circuit outlet. The first electric machine controller includes a first controller housing and first controller circuitry. The first controller housing is removably attached to the cooling plate and overlaps the fluid cooling circuit. The first controller circuitry is disposed within an interior of the first controller housing. The first controller circuitry is in thermal communication with the cooling plate through a wall of the first controller housing. The second electric machine controller includes a second controller housing and second controller circuitry. The second controller housing is removably attached to the cooling plate and overlaps the fluid cooling circuit. The second controller circuitry is disposed within an interior of the second controller housing. The second controller circuitry is in thermal communication with the cooling plate through a wall of the second controller housing.

According to another aspect of the present disclosure, another assembly is provided for an aircraft powerplant. This assembly includes a cooling plate, a first electric machine controller, a second electric machine controller, an electrical system, a first electric machine and a second electric machine. The cooling plate includes a fluid cooling circuit, a cooling circuit inlet and a cooling circuit outlet. The fluid cooling circuit extends within the cooling plate from the cooling circuit inlet to the cooling circuit outlet. The first electric machine controller is removably attached to the cooling plate and overlaps the fluid cooling circuit. The first electric machine controller is in thermal communication with the cooling plate through an interface between the first electric machine controller and the cooling plate. The second electric machine controller is removably attached to the cooling plate and overlaps the fluid cooling circuit. The second electric machine controller is in thermal communication with the cooling plate through an interface between the second electric machine controller and the cooling plate. The first electric machine is electrically coupled to the electrical system through the first electric machine controller. The second electric machine is electrically coupled to the electrical system through the second electric machine controller.

According to still another aspect of the present disclosure, another assembly is provided for an aircraft powerplant. This assembly includes a cooling plate, a first electric machine controller and a second electric machine controller. The cooling plate includes a fluid cooling circuit, a cooling circuit inlet and a cooling circuit outlet. The fluid cooling circuit extends within the cooling plate from the cooling circuit inlet to the cooling circuit outlet. The cooling plate extends circumferentially around an axis between a first circumferential side of the cooling plate and a second circumferential side of the cooling plate. The cooling plate extends radially between an inner side of the cooling plate and an outer side of the cooling plate. The cooling plate includes a first planar surface and a second planar surface at the outer side of the cooling plate. The first electric machine controller is removably attached to the cooling plate and overlaps the fluid cooling circuit. The first electric machine controller radially contacts the first planar surface. The second electric machine controller is removably attached to the cooling plate and overlaps the fluid cooling circuit. The second electric machine controller radially contacts the second planar surface.

The fluid cooling circuit may be internal to the cooling plate.

The fluid cooling circuit may be discrete from and fluidly decoupled from the first electric machine controller and the second electric machine controller.

The assembly may also include a cooling system. The cooling system may include the cooling plate, a heat exchanger and a cooling loop. The cooling loop may include and extend through the fluid cooling circuit and one or more passages within the heat exchanger. The cooling system may be configured to circulate a cooling fluid through the cooling loop between the cooling plate and the heat exchanger.

The cooling fluid may be a liquid coolant.

The cooling system may also include a reservoir fluidly coupled along the cooling loop between an outlet from the one or more passages within the heat exchanger and the cooling circuit inlet.

The cooling system may also include a pump fluidly coupled along the cooling loop between an outlet from the one or more passages within the heat exchanger and the cooling circuit inlet.

The pump may be controlled by the first electric machine controller and/or the second electric machine controller.

The assembly may also include a third controller discrete from the first electric machine controller and/or the second electric machine controller. The pump may be controlled by the third controller.

The fluid cooling circuit may include a first circuit passage and a second circuit passage. The first circuit passage and the second circuit passage may be arranged in parallel between the cooling circuit inlet and the cooling circuit outlet. The first controller housing may overlap the first circuit passage. The second controller housing may overlap the second circuit passage.

The fluid cooling circuit may include a first circuit passage and a second circuit passage. The first circuit passage and the second circuit passage may be arranged in series between the cooling circuit inlet and the cooling circuit outlet. The first controller housing may overlap the first circuit passage. The second controller housing may overlap the second circuit passage.

The fluid cooling circuit may also include a plurality of crossover passages fluidly coupled with and in parallel between the first circuit passage and the second circuit passage.

The cooling circuit inlet and the cooling circuit outlet may be located on different sides of the cooling plate.

The cooling circuit inlet and the cooling circuit outlet may be located on a common side of the cooling plate.

The cooling plate may also include a second fluid cooling circuit, a second cooling circuit inlet and a second cooling circuit outlet. The second fluid cooling circuit may be discrete from the fluid cooling circuit within the cooling plate. The second fluid cooling circuit may extend within the cooling plate from the second cooling circuit inlet to the second cooling circuit outlet.

The second fluid cooling circuit may be fluidly decoupled from the fluid cooling circuit outside of the cooling plate.

The cooling plate may extend circumferentially around an axis between a first circumferential side of the cooling plate and a second circumferential side of the cooling plate. The cooling plate may extend radially between an inner side of the cooling plate and an outer side of the cooling plate. The cooling plate may include a first planar surface and a second planar surface at the outer side of the cooling plate. The first controller housing may radially contact and/or may be removably attached to the first planar surface. The second controller housing may radially contact and/or may be removably attached to the second planar surface.

The first controller housing may contact and/or may be thermally coupled to the cooling plate through a meshed interface between the first controller housing and the cooling plate. The second controller housing may contact and/or may be thermally coupled to the cooling plate through a meshed interface between the second controller housing and the cooling plate.

The cooling plate may be configured as a monolithic body.

The assembly may also include a fan rotor and a fan case housing the fan rotor. The cooling plate may be flexibly mounted to the fan case with an air gap formed by and extending radially between the fan case and the cooling plate.

The assembly may also include an electrical system, a first electric machine and a second electric machine. The first electric machine may be electrically coupled to the electrical system through the first electric machine controller. The first controller circuitry may be configured to control a first flow of electricity between the electrical system and the first electric machine. The second electric machine may be electrically coupled to the electrical system through the second electric machine controller. The second controller circuitry may be configured to control a second flow of electricity between the electrical system and the second electric machine.

The assembly may also include an engine core, a first electric machine and a second electric machine. The engine core may include a flowpath, a compressor section, a combustor section, a turbine section, a first rotating assembly and a second rotating assembly. The flowpath may extend through the compressor section, the combustor section and the turbine section. The first rotating assembly may include a first bladed rotor disposed in the compressor section or the turbine section. The second rotating assembly may include a second bladed rotor disposed in the compressor section or the turbine section. The first electric machine may be electrically coupled to the first electric machine controller. The first electric machine may include a first electric machine rotor operatively coupled to and rotatable with the first rotating assembly. The second electric machine may be electrically coupled to the second electric machine controller. The second electric machine may include a second electric machine rotor operatively coupled to and rotatable with the second rotating assembly.

The present disclosure may include any one or more of the individual features disclosed above and/or below alone or in any combination thereof.

The foregoing features and the operation of the invention will become more apparent in light of the following description and the accompanying drawings.

### BRIEF DESCRIPTION OF THE DRAWINGS

FIG. 1 is a partial schematic illustration of an aircraft propulsion system.
FIG. 2 is a schematic illustration of a portion of the aircraft propulsion system at an electric machine system.
FIG. 3 is a schematic illustration of a portion of the aircraft propulsion system at a fluid cooling system.
FIG. 4 is a schematic plan view illustration of a fluid cooling plate with multiple electric machine controllers.
FIG. 5 is a partial cross-sectional illustration of the aircraft propulsion system at the fluid cooling plate.
FIG. 6 is a sectional illustration of a portion of a meshed interface between the fluid cooling plate and a controller housing.
FIGS. 7-12 are schematic plan view illustrations of various alternative fluid cooling plate arrangements with the electric machine controllers.
FIG. 13 is a sectional illustration of the fluid cooling plate having a monolithic body.
FIG. 14 is a sectional illustration of the fluid cooling plate having a multi-segment body.

### DETAILED DESCRIPTION

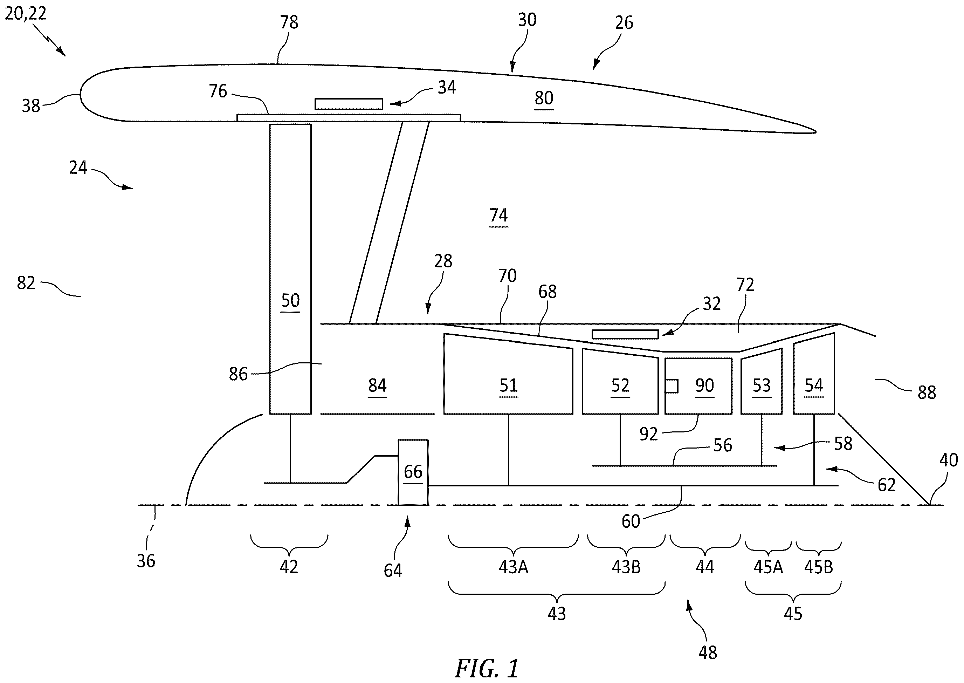

FIG. 1 illustrates a powerplant 20 for an aircraft. The aircraft may be an airplane, a rotorcraft (e.g., a helicopter), a drone (e.g., an unmanned aerial vehicle (UAV)) or any other manned or unmanned aerial vehicle or system. For ease of description, the aircraft powerplant 20 is described below as a propulsion system 22 for the aircraft and, more particularly, as a turbofan propulsion system. The aircraft powerplant 20 of the present disclosure, however, is not limited to such an exemplary propulsion system. The aircraft propulsion system 22, for example, may alternatively be configured as a turbojet propulsion system, a turboprop propulsion system, a turboshaft propulsion system, a propfan propulsion system, a pusher fan propulsion system, or any other type of ducted or open rotor propulsion system. Moreover, the aircraft powerplant 20 is not limited to propulsion system applications. The aircraft powerplant 20, for example, may alternatively (or also) be configured as an electrical power system for the aircraft; e.g., an auxiliary power unit (APU).

The aircraft propulsion system 22 includes a gas turbine engine 24 (e.g., a turbofan engine) housed within a stationary engine housing 26, which engine housing 26 of FIG. 1 includes an inner housing structure 28 and an outer housing structure 30. The aircraft propulsion system 22 also includes an electric machine system 32 and a fluid cooling system 34. The aircraft propulsion system 22 extends axially along an axis 36 between an axial forward, upstream end 38 of the aircraft propulsion system 22 and an axial aft, downstream end 40 of the aircraft propulsion system 22. Briefly, the axis 36 may be a centerline axis of the aircraft propulsion system 22, the turbine engine 24 and/or one or more of its members. The axis 36 may also or alternatively be a rotational axis for one or more members of the turbine engine 24.

The turbine engine 24 of FIG. 1 includes a propulsor section 42 (e.g., a fan section), a compressor section 43, a combustor section 44 and a turbine section 45. The compressor section 43 of FIG. 1 includes a low pressure compressor (LPC) section 43A and a high pressure compressor (HPC) section 43B. The turbine section 45 of FIG. 1 includes a high pressure turbine (HPT) section 45A and a low pressure turbine (LPT) section 45B. Here, at least (or only) the LPC section 43A, the HPC section 43B, the combustor section 44, the HPT section 45A and the LPT section 45B collectively form a core 48 of the turbine engine 24.

The engine sections 42-45B may be arranged sequentially along the axis 36 within the engine housing 26. The propulsor section 42 includes a bladed propulsor rotor 50; e.g., a fan rotor. The LPC section 43A includes a bladed low pressure compressor (LPC) rotor 51. The HPC section 43B includes a bladed high pressure compressor (HPC) rotor 52. The HPT section 45A includes a bladed high pressure turbine (HPT) rotor 53. The LPT section 45B includes a bladed low pressure turbine (LPT) rotor 54.

The HPC rotor 52 is coupled to and rotatable with the HPT rotor 53. The HPC rotor 52 of FIG. 1, for example, is connected to the HPT rotor 53 through a high speed shaft 56. At least (or only) the HPC rotor 52, the HPT rotor 53 and the high speed shaft 56 collectively form a high speed rotating assembly 58; e.g., a high speed spool of the engine core 48. This high speed rotating assembly 58 of FIG. 1 and its members 52, 53 and 56 are rotatable about the axis 36. However, it is contemplated the high speed rotating assembly 58 may alternatively be rotatable about another axis radially and/or angularly offset from the rotational axis of the propulsor rotor 50 and/or the centerline axis of the turbine engine 24.

The LPC rotor 51 is coupled to and rotatable with the LPT rotor 54. The LPC rotor 51 of FIG. 1, for example, is connected to the LPT rotor 54 through a low speed shaft 60. At least (or only) the LPC rotor 51, the LPT rotor 54 and the low speed shaft 60 collectively form a low speed rotating assembly 62; e.g., a low speed spool of the engine core 48. This low speed rotating assembly 62 is further coupled to the propulsor rotor 50 through a drivetrain 64. The drivetrain 64 may be configured as a geared drivetrain, where a geartrain 66 (e.g., a transmission, a speed change device, an epicyclic geartrain, etc.) is disposed between and operatively couples the propulsor rotor 50 to the low speed rotating assembly 62 and its LPT rotor 54. With this arrangement, the propulsor rotor 50 may rotate at a different (e.g., slower) rotational speed than the low speed rotating assembly 62 and its LPT rotor 54. Alternatively, the drivetrain 64 may be configured as a direct drive drivetrain, where the geartrain 66 is omitted. With such an arrangement, the propulsor rotor 50 rotates at a common (the same) rotational speed as the low speed rotating assembly 62 and its LPT rotor 54. The low speed rotating assembly 62 of FIG. 1 and its members 51, 54 and 60 as well as the propulsor rotor 50 are rotatable about the axis 36. However, it is contemplated the low speed rotating assembly 62 may alternatively be rotatable about another axis radially and/or angularly offset from the rotational axis of the propulsor rotor 50 and/or the centerline axis of the turbine engine 24.

The inner housing structure 28 of FIG. 1 includes an inner case 68 (e.g., a core case) for the turbine engine 24, an inner nacelle structure 70 (sometimes referred to as an inner fixed structure (IFS)) and an internal inner housing compartment 72. The inner case 68 is disposed radially outboard of, extends axially along and may circumscribe one or more or all of the engine sections 43A-45B and their respective engine rotors 51-54. The inner case 68 may thereby house and provide a support structure for the respective engine sections 43A-45B and their respective engine rotors 51-54. The inner nacelle structure 70 is configured to provide an aerodynamic cover over the engine core 48 and its inner case 68. The inner housing compartment 72 of FIG. 1 is formed by and is disposed radially between the inner case 68 and an inner barrel of the inner nacelle structure 70. The inner housing structure 28 and its inner nacelle structure 70 may also form a radial inner peripheral boundary of a (e.g., annular) bypass flowpath 74 within the aircraft propulsion system 22.

The outer housing structure 30 of FIG. 1 includes an outer case 76 (e.g., a fan case) for the turbine engine 24, an outer nacelle structure 78 and an internal outer housing compartment 80. The outer case 76 is disposed radially outboard of, extends axially along and may circumscribe the propulsor section 42 and its propulsor rotor 50. The outer case 76 may thereby house and provide a containment structure for the propulsor section 42 and its propulsor rotor 50. The outer nacelle structure 78 is configured to provide an aerodynamic cover over the outer case 76. The outer housing compartment 80 of FIG. 1 is at least partially formed by and disposed radially between the outer case 76 and an outer portion (e.g., fan cowls) of the outer nacelle structure 78. The outer housing structure 30 and its outer nacelle structure 78 may also form a radial outer peripheral boundary of the bypass flowpath 74.

During operation, ambient air from outside of the aircraft enters the aircraft propulsion system 22 and its turbine engine 24 through an airflow inlet 82. This air is directed across the propulsor section 42 and into a (e.g., annular) core flowpath 84 and the bypass flowpath 74. The core flowpath 84 of FIG. 1 extends sequentially through the LPC section 43A, the HPC section 43B, the combustor section 44, the HPT section 45A and the LPT section 45B from an airflow inlet 86 into the core flowpath 84 to a combustion products exhaust 88 out from the core flowpath 84 and the engine core 48. The air entering the core flowpath 84 may be referred to as "core air". The bypass flowpath 74 extends through a bypass duct, which bypass flowpath 74 and bypass duct bypass (e.g., are disposed radially outboard of and extend along) the engine core 48 and the inner housing structure 28. The air within the bypass flowpath 74 may be referred to as "bypass air".

The core air is compressed by the LPC rotor 51 and the HPC rotor 52 and is directed into a (e.g., annular) combustion chamber 90 of a (e.g., annular) combustor 92 in the combustor section 44. Fuel is injected into the combustion chamber 90 by one or more fuel injectors and mixed with the compressed core air to provide a fuel-air mixture. This fuel-air mixture is ignited and combustion products thereof flow through and sequentially drive rotation of the HPT rotor 53 and the LPT rotor 54 about the axis 36. The rotation of the HPT rotor 53 and the LPT rotor 54 respectively drive rotation of the HPC rotor 52 and the LPC rotor 51 about the axis 36 and, thus, compression of the air received from the core inlet 86. The rotation of the LPT rotor 54 also drives rotation of the propulsor rotor 50. The rotation of the propulsor rotor 50 propels the bypass air through and out of the bypass flowpath 74. The propulsion of the bypass air may account for a majority of thrust generated by the turbine engine 24 of FIG. 1.

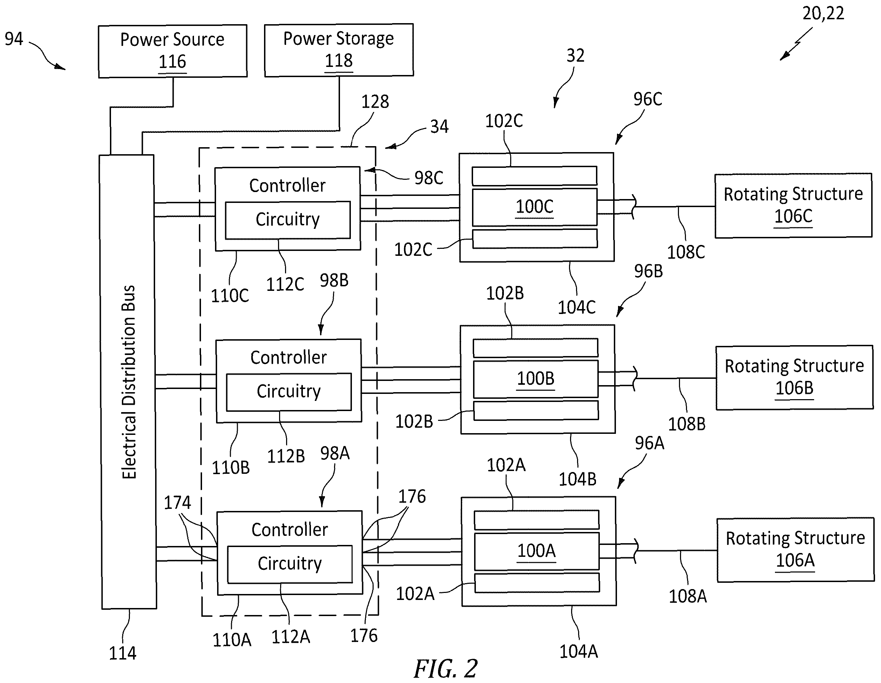

Referring to FIG. 2, the electric machine system 32 is electrically coupled to an electrical system 94 for the aircraft. The electric machine system 32 of FIG. 2 includes one or more electric machines 96A-C (generally referred to as "96") and one or more electric machine (EM) controllers 98A-C (generally referred to as "98"). For ease of description, each electric machine 96 of FIG. 2 is described below as being electrically coupled to, controlled by and/or otherwise associated with a single, dedicated one of the EM controllers 98. However, it is contemplated a single EM controller may alternatively be electrically coupled to, may control and/or may otherwise be associated with multiple electric machines. It is also contemplated multiple EM controllers may be electrically coupled to, may control and/or may otherwise be associated with one or more common electric machines.

Each electric machine 96A-C of FIG. 2 includes an electric machine rotor 100A-C (generally referred to as "100"), an electric machine stator 102A-C (generally referred to as "102") and an electric machine housing 104A-C (generally referred to as "104"). The machine rotor 100 is rotatable about a rotational axis of the machine rotor 100, which rotational axis may also be an axial centerline of the electric machine 96. The machine stator 102 of FIG. 2 is radially outboard of and circumscribes the machine rotor 100. With this arrangement, each electric machine 96 is configured as a radial flux electric machine. The electric machines 96 of the present disclosure, however, are not limited to such an exemplary rotor-stator configuration nor to radial flux arrangements. The machine rotor 100, for example, may alternatively be radially outboard of and circumscribe the machine stator 102. In another example, the machine rotor 100 may be axially next to the machine stator 102 configuring the respective electric machine 96 as an axial flux electric machine. Referring again to FIG. 2, the machine rotor 100 and the machine stator 102 are at least partially or completely housed within the machine housing 104.

Each electric machine 96A-C is operatively coupled to a rotating structure 106A-C (generally referred to as "106") of the aircraft propulsion system 22 (see FIG. 1). Each machine rotor 100A-C of FIG. 2, for example, is mechanically coupled to and rotatable with the respective rotating structure 106A-C through a drivetrain 108A-C (generally referred to as "108"). This drivetrain 108 may be configured as or otherwise include a shaft, a tower shaft assembly, a gearbox, and/or the like. The rotating structure 106 may be a part of the turbine engine 24 (see FIG. 1). The rotating structure 106, for example, may be configured as one of the engine rotating assemblies 58, 62 (see FIG. 1). Alternatively, the rotating structure 106 may be part of an accessory for the turbine engine 24 (see FIG. 1). The rotating structure 106, for example, may be configured as a pump rotor, an auxiliary compressor rotor, an actuator rotor, or the like. For ease of description, each machine rotor 100 of FIG. 2 is described below as being coupled to and rotatable with a unique one of the rotating structures 106 of the aircraft propulsion system. However, it is contemplated multiple machine rotors may alternatively be coupled to and rotatable with a common rotating structure. It is also contemplated a single one of the machine rotors may be coupled to and rotatable with multiple rotating structures, directly or through another device such as a differential or a clutch system. Rotating structures may include one or more components of the high speed rotating assembly 58 and/or the low speed rotating assembly 62. In some embodiments, the propulsion system 22 may include a power turbine assembly decoupled from the high speed rotating assembly 58 and the low speed rotating assembly 62 and configured to drive the propulsor section 42, such as via the drivetrain 64. In such embodiments, the rotating structure may include one or more components of the power turbine assembly.

Each electric machine 96 of FIG. 2 may be configurable as an electric motor and/or an electric generator; e.g., an electric motor-generator. For example, during a motor mode of operation, a respective electric machine 96 may operate as the electric motor to convert electricity received from the aircraft electrical system 94 through the respective EM controller 98. The machine stator 102, for example, may generate an electromagnetic field with the machine rotor 100 using the electricity. This electromagnetic field may drive rotation of the machine rotor 100. The machine rotor 100, in turn, may provide mechanical power to and drive rotation of the respective rotating structure 106 through the respective drivetrain 108. This mechanical power may be provided to boost power or completely power the rotation of the respective rotating structure 106. By contrast, during a generator mode of operation, the electric machine 96 may operate as the electric generator to convert mechanical power received from the respective rotating structure 106 into electricity. Rotation of the machine rotor 100, for example, may be rotationally driven by rotation of the respective rotating structure 106 through the respective drivetrain 108. The rotation of the machine rotor 100 may generate an electromagnetic field with the machine stator 102, and the machine stator 102 may convert energy from the electromagnetic field into electricity. The respective electric machine 96 may then provide this electricity to the aircraft electrical system 94 through the respective EM controller 98 for storage and/or further use. The electric machines 96 of the present disclosure, however, are not limited to such exemplary operation. For example, one, some or all of the electric machines 96 may alternatively each be configured as a dedicated electric motor; e.g., without the electric generator functionality. One, some or all of the electric machines 96 may still alternatively each be configured as a dedicated electric generator; e.g., without the electric motor functionality.

Each EM controller 98A-C includes a controller housing 110A-C (generally referred to as "110") and internal controller circuitry 112A-C (generally referred to as "112"). The controller housing 110 may be configured as an enclosed case (e.g., a closed or sealed container) for the respective controller circuitry 112. The controller circuitry 112 is disposed within an interior of the controller housing 110; e.g., an internal chamber or other volume(s) within and enclosed by the controller housing 110. The controller circuitry 112 includes various electrical components, connectors and the like. Examples of the electrical components include, but are not limited to, printed circuit board(s) (PCB(s)), electrical inductor(s), electrical inverter(s), electrical amplifier(s), electrical switch(es) (e.g., contactor(s), relay(s), solid state power controller(s), etc.), processing device(s), memory, communication module(s), electrical transformer(s), electrical rectifier(s), and/or the like.

Each EM controller 98 and its controller circuitry 112 are configured to control operation of a respective one of the electric machines 96. For example, when operating as the electric motor, the respective EM controller 98 and its controller circuitry 112 are configured to regulate a flow of electricity from the aircraft electrical system 94 to the respective electric machine 96. This electricity flow regulation may include: (a) turning-on the flow of electricity from the aircraft electrical system 94 to the respective electric machine 96 (e.g., electrically coupling the respective electric machine 96 to the aircraft electrical system 94); (b) turning-off the flow of electricity from the aircraft electrical system 94 to the respective electric machine 96 (e.g., electrically decoupling the respective electric machine 96 from the aircraft electrical system 94); (c) moderating the flow of electricity from the aircraft electrical system 94 to the respective electric machine 96. Here, the respective EM controller 98 operates as a motor controller. In another example, when operating as the electric generator, the respective EM controller 98 and its controller circuitry 112 are configured to regulate a flow of electricity from the respective electric machine 96 to the aircraft electrical system 94. This electricity flow regulation may include: (a) turning-on the flow of electricity from the respective electric machine 96 to the aircraft electrical system 94 (e.g., electrically coupling the respective electric machine 96 to the aircraft electrical system 94); (b) turning-off the flow of electricity from the respective electric machine 96 to the aircraft electrical system 94 (e.g., electrically decoupling the respective electric machine 96 from the aircraft electrical system 94); (c) moderating the flow of electricity from the respective electric machine 96 to the aircraft electrical system 94. Here, the respective EM controller 98 operates as a generator controller.

The aircraft electrical system 94 of FIG. 2 includes an electrical distribution bus 114. This aircraft electrical system 94 may also include a power source 116 and/or a power storage 118. The electrical distribution bus 114 is electrically coupled to each of the electric machines 96 through their respective EM controllers 98. The electrical distribution bus 114 is also electrically coupled to the power source 116 and the power storage 118. With this arrangement, the electrical distribution bus 114 provides an intermediate connection between the various electrical aircraft propulsion system members 98A, 98B, 98C, 116 and 118. The power source 116 may be an electric generator powered by the turbine engine 24 (see FIG. 1) or an electric generator powered by another aircraft powerplant; e.g., an engine of a companion aircraft propulsion system, an engine of an auxiliary power unit (APU), etc. The power storage 118 is configured to receive electricity from the electrical distribution bus 114 for storage. The power storage 118 is also configured to provide the stored electricity to the electrical distribution bus 114. The power storage 118, for example, may be configured as or otherwise include one or more electricity storage devices; e.g., batteries, super capacitors, etc. Of course, it is contemplated one or more of the electric machines 96 (e.g., operating as the electric generator(s)) may also or alternatively operate a power source for another one or more of the electric machines 96 (e.g., operating as the electric motor(s)).

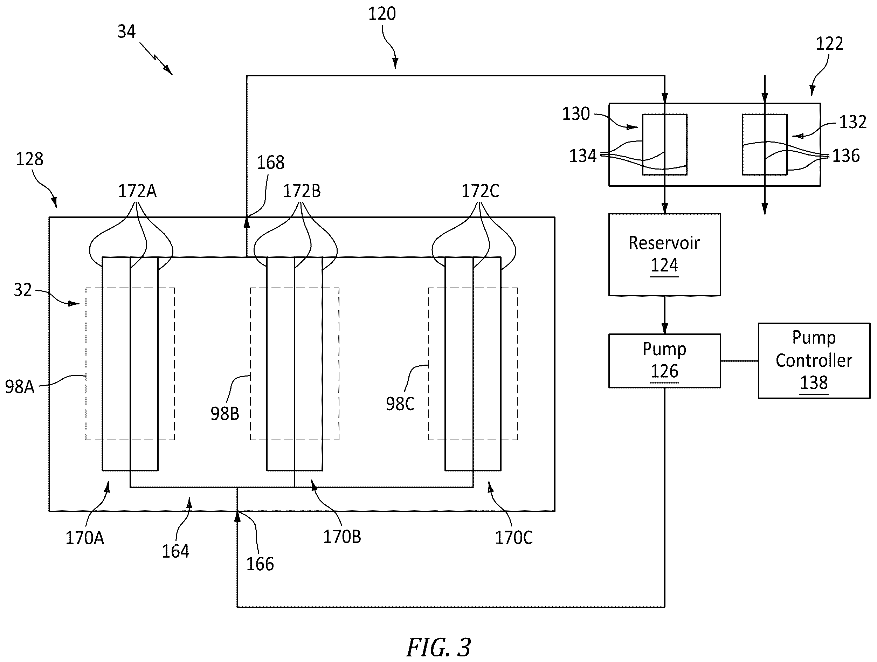

During operation of each electric machine 96, the respective EM controller 98 and its controller circuitry 112 may heat up; e.g., generate waste heat energy. To promote efficient EM controller operation and/or prevent EM controller heat-related degradation, a temperature of each EM controller 98 may be regulated (e.g., the heat energy may be dissipated) using the fluid cooling system 34. Referring to FIG. 3, the fluid cooling system 34 includes a cooling system flowpath 120, a heat exchanger 122, a fluid reservoir 124, a fluid pump 126 and a fluid cooling plate 128.

The cooling system flowpath 120 may be configured as a closed fluid cooling loop. The cooling system flowpath 120 of FIG. 3, for example, extends longitudinally out of the fluid reservoir 124, through the fluid pump 126, the cooling plate 128 and the heat exchanger 122, and back into the fluid reservoir 124. With such an arrangement, the fluid cooling system 34 may circulate a (e.g., liquid) cooling fluid such as, but not limited to, coolant, lubricant, or the like. The present disclosure, however, is not limited to such an exemplary closed loop arrangement. The cooling system flowpath 120, for example, may alternatively be configured as an open fluid cooling loop. With such an open loop arrangement, the cooling system flowpath 120 may not feed back to the fluid reservoir 124. Rather, the cooling system flowpath 120 may supply the cooling fluid to another component (or components) of the aircraft propulsion system 22; e.g., an actuator, an injector, etc. Still alternatively, the fluid reservoir 124 may be replaced by a bleed from the core flowpath 84 or another pressurized air source where the cooling fluid is compressed air; e.g., compressed core air.

The heat exchanger 122 of FIG. 3 includes a plurality of fluidly discrete internal heat exchanger (HX) circuits 130 and 132. Each of these HX circuits 130, 132 may include one or more (e.g., parallel) flow passages 134, 136 within the heat exchanger 122. The first HX circuit 130 of FIG. 3 is part of and is thereby fluidly coupled inline with the cooling system flowpath 120. The second HX circuit 132 of FIG. 3 is part of and is thereby fluidly coupled inline with a flowpath of another fluid system of the aircraft propulsion system 22; e.g., a bleed air system, a nacelle air system, a fuel system, a lubrication system, etc. The HX circuits 130 and 132 and their flow passages 134 and 136 may be arranged to provide the heat exchanger 122 with a parallel flow configuration, a cross-flow configuration, a counterflow configuration, or a hybrid configuration including any two or more of the foregoing configurations. With this arrangement, the heat exchanger 122 is configured to exchange heat energy between (a) the cooling fluid flowing through the cooling system flowpath 120 and its first HX circuit 130 and (b) another working fluid (e.g., compressed air, fuel, lubricant, etc.) flowing through the second HX circuit 132.

The fluid reservoir 124 is configured to store a quantity of the cooling fluid before, during and/or after cooling system operation. The fluid reservoir 124, for example, may be configured as or otherwise include a tank, a cylinder, a pressure vessel, a bladder or any other type of fluid storage container.

The fluid pump 126 is configured to direct (e.g., circulate) the cooling fluid through the cooling system flowpath 120. The fluid pump 126 is controlled by a pump controller 138. This pump controller 138 may be discrete from the EM controllers 98. The pump controller 138, for example, may be part of an onboard engine controller such as an electronic engine controller (EEC), an electronic control unit (ECU), a full-authority digital engine controller (FADEC), etc. Alternatively, the pump controller 138 may also be discrete from the onboard engine controller. Still alternatively, the pump controller 138 may be integrated into the controller circuitry 112 (see FIG. 2) of one or more of the EM controllers 98.

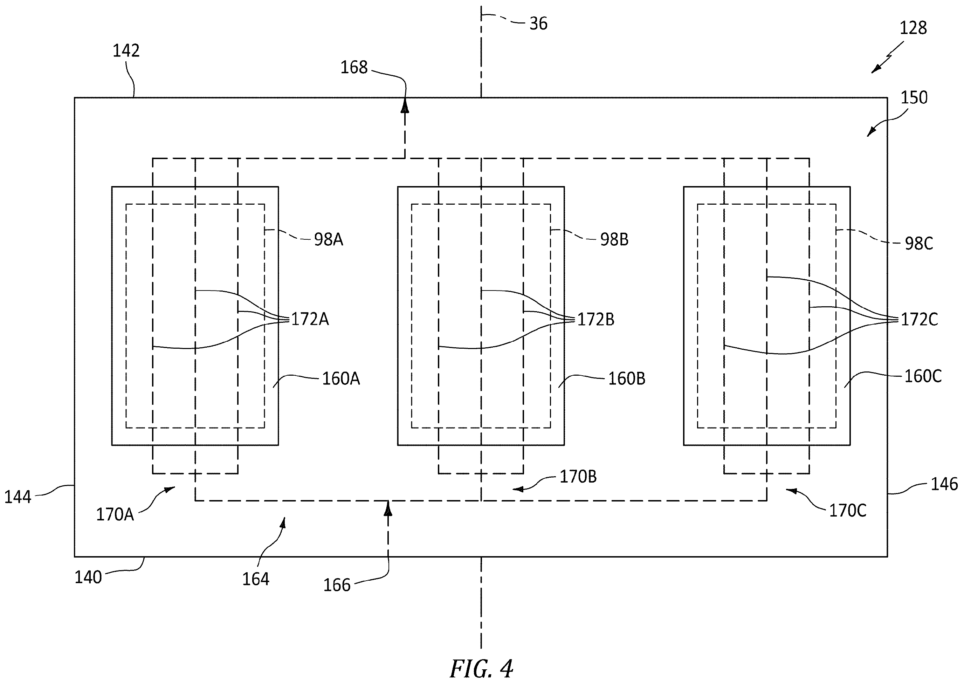

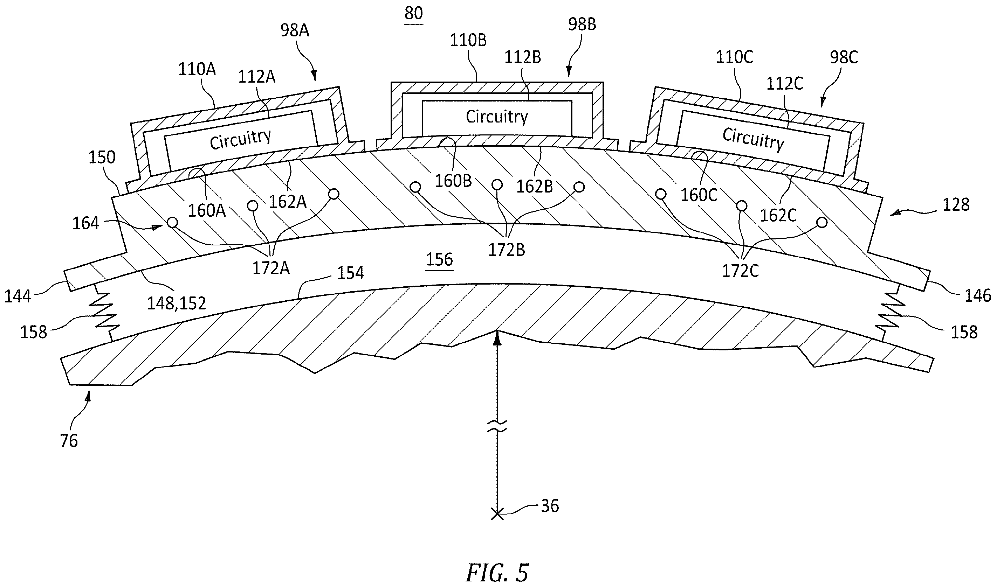

Referring to FIG. 4, the cooling plate 128 extends axially along the axis 36 from an axial first side 140 (e.g., forward side) of the cooling plate 128 to an axial second side 142 (e.g., an aft side) of the cooling plate 128. The cooling plate 128 extends circumferentially about (e.g., partially around) the axis 36 between and to opposing circumferential sides 144 and 146 of the cooling plate 128. The cooling plate 128 may thereby have an arcuate configuration. Referring to FIG. 5, the cooling plate 128 extends radially from a radial inner side 148 of the cooling plate 128 to a radial outer side 150 of the cooling plate 128.

At the plate inner side 148, the cooling plate 128 may have a curved inner surface 152. The plate inner side 148 and its plate inner surface 152 may have geometries (e.g., a cylindrical segment geometry) tailored to substantially match (e.g., conform to, have an identical shape as, etc.) a geometry of a structure to which the cooling plate 128 is mounted. The cooling plate 128 of FIG. 5, for example, is disposed within the outer housing compartment 80 (see also FIG. 1) radially outboard of the outer case 76. This cooling plate 128 is mounted to the outer case 76, and the plate inner side 148 and its plate inner surface 152 may be tailored to match an outer surface 154 of the outer case 76. However, the cooling plate 128 may be spaced radially outboard from the outer case 76 by a radial air gap 156. This air gap 156 may facilitate deformations in the outer case 76 without affecting the cooling plate 128. Moreover, the cooling plate 128 may be flexibly mounted to the outer case 76 to reduce transmission of vibrations from the outer case 76, through the cooling plate 128, into the EM controllers 98. The cooling plate 128 of FIG. 5, for example, is mounted to the outer case 76 through one or more flexible mounts 158; e.g., spring mounts, rubber mounts, etc.

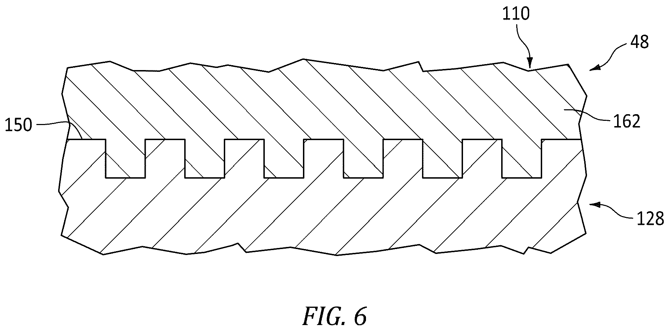

At the plate outer side 150, the cooling plate 128 may include one or more controller lands 160A-C (generally referred to as "160"); e.g., mounting surfaces. Each of these controller lands 160 is configured to mate with a respective one of the EM controllers 98. For example, each controller land 160A-C may have a flat planar geometry which matches a flat planar geometry of a bottom wall 162A-C (generally referred to as "162") of a respective one of the controller housings 110A-C. The housing wall 162 may thereby sit on and radially engage (e.g., contact, abut against, lay flush over, etc.) the respective controller land 160. Each EM controller 98 and its controller housing 110 may be removably attached to the cooling plate 128, for example by one or more mechanical fasteners; e.g., bolts. With the foregoing arrangement, each EM controller 98 is in thermal communication with the cooling plate 128. More particularly, the controller circuitry 112 of each EM controller 98 is thermally coupled to the cooling plate 128 - via conduction - through the respective controller housing 110 and its housing wall 162. This thermal communication may be enhanced by providing a thermal paste or other thermal coupling with high thermal conductivity properties at an interface between the cooling plate 128 and the respective controller housing 110. The thermal communication may be further enhanced by increasing surface area contact between each controller housing 110 and the cooling plate 128 at the interface therebetween. For example, referring to FIG. 6, an inner surface of each controller housing 110 and the respective controller land 160 may be grooved or otherwise non-flat to provide a (e.g., a tongue and groove) meshed interface between the respective controller housing 110 and the cooling plate 128.

Referring to FIG. 4, the cooling plate 128 is configured with a fluid cooling circuit 164. The fluid cooling circuit 164 of FIG. 4 is internal to (e.g., formed within, embedded within) a material mass of the cooling plate 128. The fluid cooling circuit 164 extends (e.g., completely) within the cooling plate 128 between (a) a cooling circuit inlet 166 into the cooling plate 128 and its fluid cooling circuit 164 and (b) a cooling circuit outlet 168 from the cooling plate 128 and its fluid cooling circuit 164. The fluid cooling circuit 164 of FIG. 4 includes one or more subcircuits 170A-C (generally referred to as "170"). Each of these subcircuits 170 is disposed within the cooling plate 128. Each of the subcircuits 170 extends along and is located next to (e.g., underneath) a respective one of the controller lands 160 and, thus, a respective one of the EM controllers 98. The subcircuits 170 of FIG. 4 are arranged in parallel between the cooling circuit inlet 166 and the cooling circuit outlet 168. Each subcircuit 170A-C of FIG. 4 includes one or more circuit passages 172A-C (generally referred to as "172"). These circuit passages 172A-C of FIG. 4 are arranged in parallel within the respective subcircuit 170A-C between an inlet into the respective subcircuit 170A-C and the cooling circuit outlet 168. The circuit passages 172 of each subcircuit 170 are arranged in a pattern, within the material mass of the cooling plate 128, which extends along and is located next to (e.g., underneath) a respective one of the controller lands 160 and, thus, a respective one of the EM controllers 98. With this arrangement, each subcircuit 170 is operable to flow a quantity of the cooling fluid within the cooling plate 128 in close proximity and in thermal communication with the respective EM controller 98 and its controller circuitry 112.

Referring to FIG. 3, during operation of the fluid cooling system 34, the fluid pump 126 directs (e.g., pumps) relatively cool cooling fluid out of the fluid reservoir 124, through the cooling system flowpath 120, to the cooling plate 128. Referring to FIG. 5, as the cooling fluid flows through the fluid cooling circuit 164 and its circuit passages 172 within the cooling plate 128, heat energy generated by the controller circuitry 112 may be transferred out of the EM controllers 98 and into the cooling fluid. The heat energy transfer thereby dissipates the heat energy in (e.g., cools) the EM controllers 98 and their controller circuitry 112 while also heating the cooling fluid. Referring to FIG. 3, the now heated cooling fluid is directed from the cooling plate 128, through the cooling system flowpath 120, to the heat exchanger 122. Within the heat exchanger 122, at least some or all of the heat energy previously transferred into the cooling fluid at the cooling plate 128 may be transferred out of the cooling fluid into the other working fluid thereby cooling the cooling fluid. The now cooled cooling fluid is directed from the heat exchanger 122, through the cooling system flowpath 120, back into the fluid reservoir 124 of subsequent recirculation.

During the fluid cooling system operation, the transfer of heat energy from the controller circuity 162 (see FIG. 5) into the cooling fluid and, thus, the cooling of the EM controllers 98 may be regulated using the fluid pump 126. For example, when it is sensed and/or predicted that one, some or all of the EM controllers 98 (see FIG. 5) is generating a relatively large quantity of the heat energy, the pump controller 138 may signal the fluid pump 126 to initiate or increase a flowrate of the cooling fluid to the cooling plate 128. In another example, when it is sensed and/or predicted that one, some or all of the EM controllers 98 (see FIG. 5) is generating a relatively small quantity of the heat energy or the EM controllers 98 are non-operational (e.g., depowered), the pump controller 138 may signal the fluid pump 126 to terminate or decrease the flowrate of the cooling fluid to the cooling plate 128.

With the foregoing arrangement, each EM controller 98 of FIGS. 2 and 5 may be configured as a discrete line replaceable unit (LRU). For example, each EM controller 98 may be readily removed by a technician (a) by unplugging electrical connections (e.g., 174 and 176) to the respective EM controller 98 (see FIG. 2) and (b) removing the mechanical fasteners (see FIG. 5) to detach the respective EM controller 98 from the cooling plate 128. A replacement EM controller 98 may then be readily installed (or the previous EM controller 98 may be reinstalled) by attaching the respective EM controller 98 to the cooling plate 128 with the mechanical fasteners (see FIG. 5) and plugging in the electrical connections (e.g., 174 and 176) to the respective EM controller 98 (see FIG. 2). Notably, since the cooling system flowpath 120 and its fluid cooling circuit 164 of FIG. 3 run through the cooling plate 128, the cooling system flowpath 120 is fluidly discrete and fluidly isolated from the EM controllers 98. The EM controllers 98 may thereby be removed and installed without breaking or making any fluid connections. Thus, while the fluid cooling system 34 is operable to regulate the temperatures of the EM controllers 98, the fluid cooling system 34 is mechanically discrete from the EM controllers 98 to facilitate assembly, maintenance and inspection of the EM controllers 98. In addition, by mounting each of the EM controllers 98 to the common cooling plate 128, a total thermal mass available for cooling each EM controller 98 is increased.

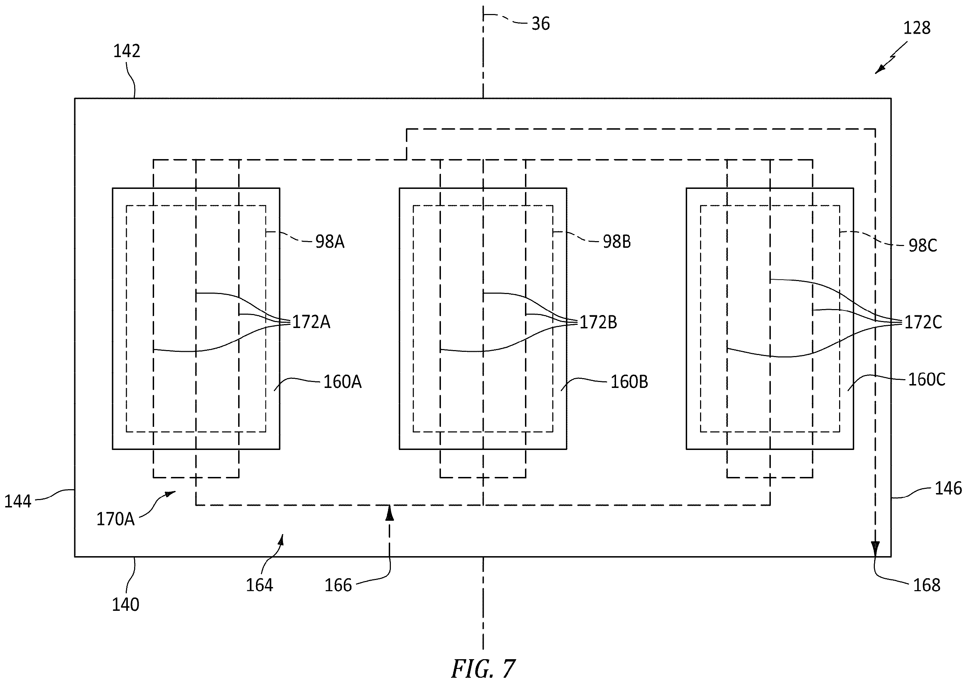

In some embodiments, referring to FIG. 4, the cooling circuit inlet 166 and the cooling circuit outlet 168 may be arranged at different sides of the cooling plate 128. The cooling circuit inlet 166 of FIG. 4, for example, is disposed at the plate axial first side 140. The cooling circuit outlet 168 of FIG. 4, for example, is disposed at the plate axial second side 142. In other embodiments, referring to FIG. 7, the cooling circuit inlet 166 and the cooling circuit outlet 168 may be arranged at a common side of the cooling plate 128. The cooling circuit inlet 166 and the cooling circuit outlet 168 of FIG. 7, for example, are disposed at the plate axial first side 140. The present disclosure, however, is not limited to the foregoing exemplary cooling circuit inlet and outlet arrangements of FIGS. 4 and 7. The cooling circuit inlet 166, for example, may be arranged at any one of the plate sides 140, 142, 144, 146. Similarly, the cooling circuit outlet 168 may be arranged at any one of the plate sides 140, 142, 144, 146, whether that side is a different side or the same side at which the cooling circuit inlet 166 is arranged.

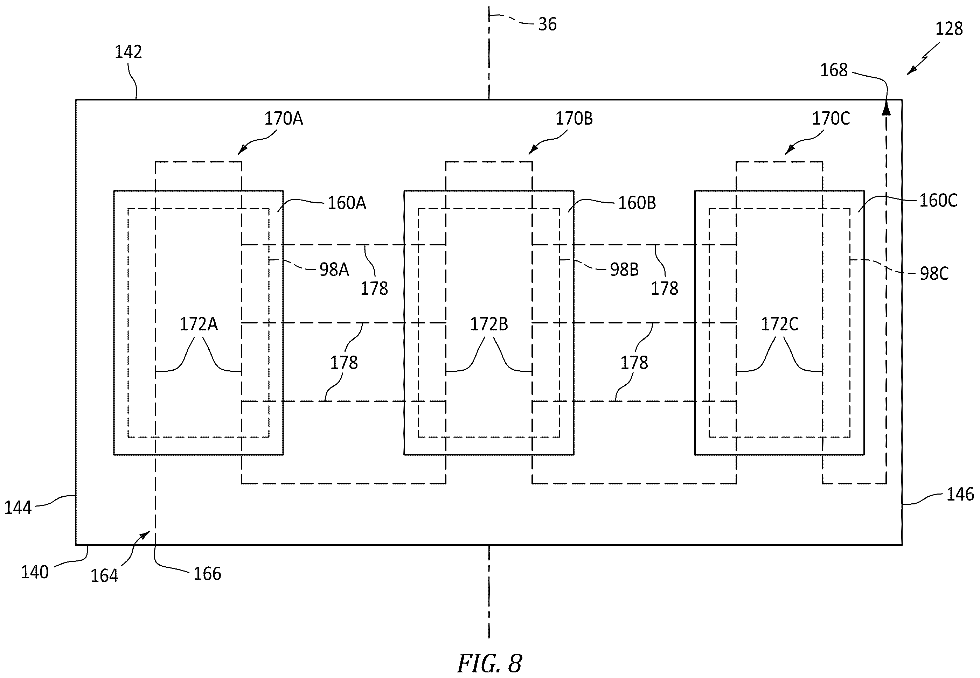

In some embodiments, referring to FIG. 4, the subcircuits 170 and their circuit passages 172 may be in parallel arrangements. In other embodiments, referring to FIG. 8, the subcircuits 170A, 170B and 170C may alternatively be arranged in series between the cooling circuit inlet 166 and the cooling circuit outlet 168. In still other embodiments, the fluid cooling circuit 164 may (or may not) also include one or more (e.g., parallel) crossover passages 178, where each set of the crossover passages 178 provides a bridge between an adjacent pair of the subcircuits 170A and 170B, 170B and 170C.

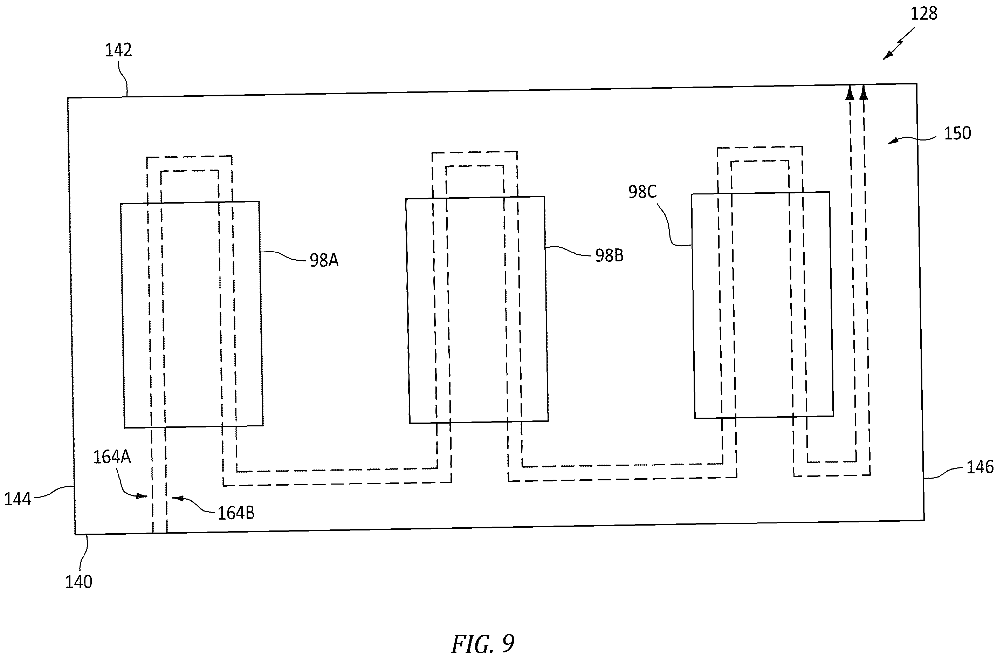

In some embodiments, referring to FIG. 4, the cooling plate 128 may be configured with a single fluid cooling circuit 164. In other embodiments, referring to FIG. 9, the cooling plate 128 may be configured with multiple fluid cooling circuits 164A and 164B (generally referred to as "164"), where each of these fluid cooling circuits 164 may have a similar configuration as described above. These fluid cooling circuits 164 may be fluidly discrete (e.g., fluidly decoupled) in the cooling plate 128. The fluid cooling circuits 164 may also be fluidly discrete outside of the cooling plate 128. Each fluid cooling circuit 164, for example, may be part of a different cooling system flowpath. With such an arrangement, a cooling fluid may (e.g., only) be directed through the second fluid cooling circuit during, for example, high heat conditions.

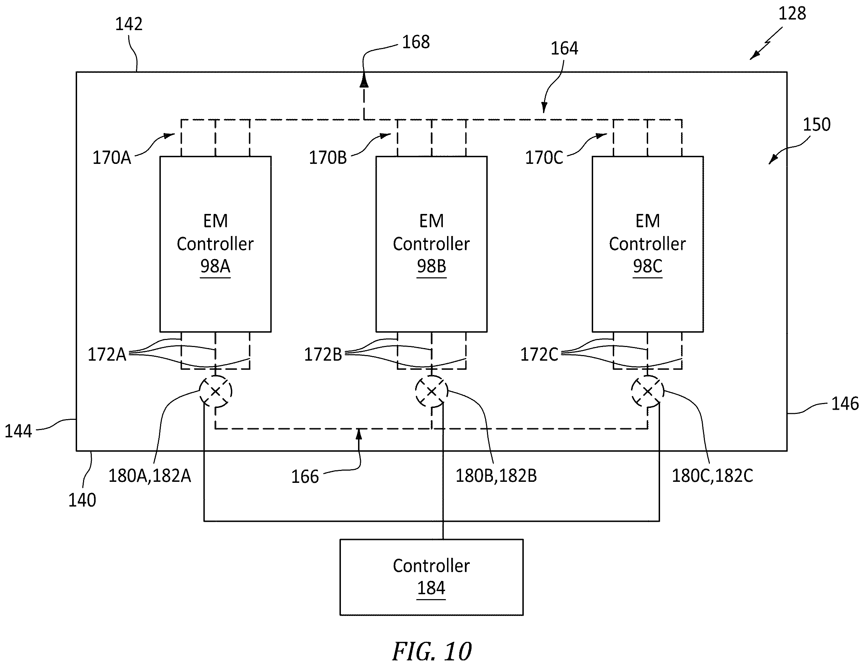

In some embodiments, referring to FIG. 10, the cooling plate 128 and its fluid cooling circuit 164 may be configured with one or more flow regulators 180A-C (generally referred to as "180") such as fluid control valves 182A-C (generally referred to as "182"). Each of these control valves 182A-C may be arranged with and operable to control the flow of the cooling fluid through a respective one of the subcircuits 170A-C and its circuit passages 172A-C. Each control valve 182 of FIG. 10, for example, is fluidly coupled between the inlet into the respective subcircuit 170 and the circuit passages 172. Each control valve 182 may also be integrated into the cooling plate 128. Each control valve 182 of FIG. 10, for example, is embedded within the cooling plate 128.

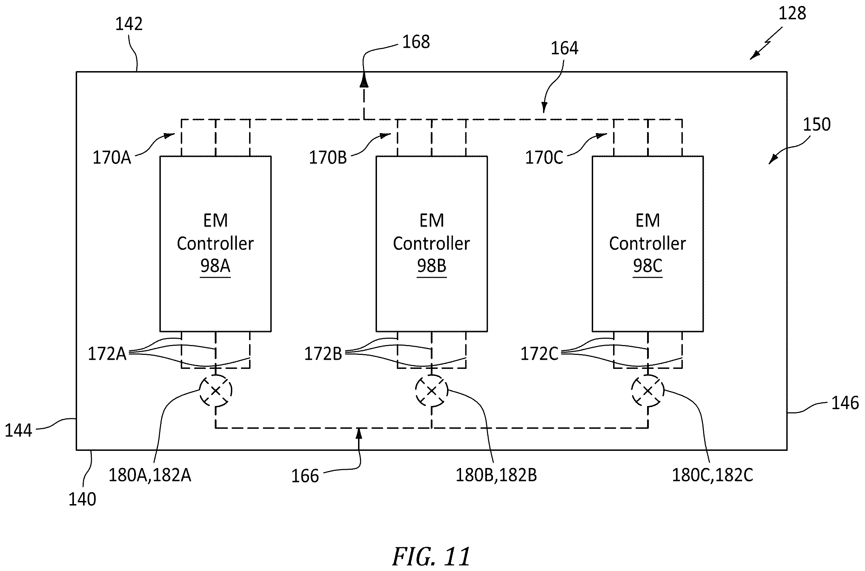

In some embodiments, one, some or all of the control valves 182 may each be configured as an actively actuated valve. Each control valve 182 of FIG. 10, for example, is in signal communication with a valve controller 184. This valve controller 184 may be discrete from the EM controllers 98 and/or the pump controller 138 (see FIG. 3). The valve controller 184, for example, may be part of the onboard engine controller. Alternatively, the valve controller 184 may also be discrete from the onboard engine controller. Still alternatively, the valve controller 184 may be integrated into the controller circuitry 112 (see FIG. 2) of one, some or all of the EM controllers 98 such that each EM controller 98 may control operation of a respective one of the control valves 182. Or, the valve controller 184 may be integrated into circuitry of the pump controller 138 (see FIG. 3) such that the pump controller 138 may control operation of the control valves 182 in addition to the fluid pump 126. In other embodiments, referring to FIG. 11, one, some or all of the control valves 182 may each be configured as a passively actuated valve. Each control valve 182, for example, may include a heat affected element which opens or closes an orifice based on a temperature of the surrounding material mass of the cooling plate 128.

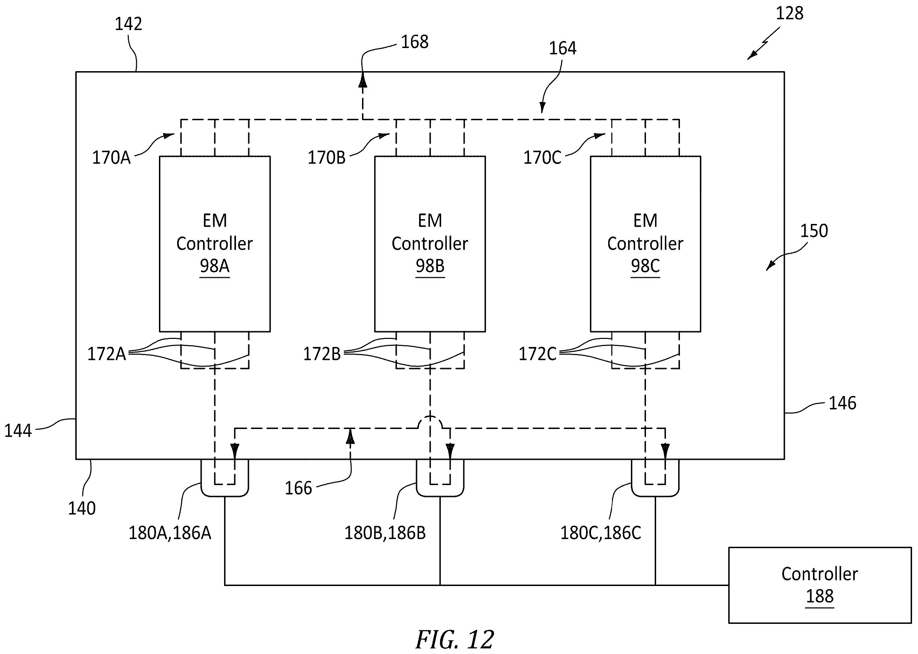

While the flow regulators 180 are described above as the control valves 182, the present disclosure is not limited to such an exemplary configuration. For example, referring to FIG. 12, each flow regulator 180A-C may alternatively be configured as or otherwise include a fluid pump 186A-C (generally referred to as "186"). Each of these fluid pumps 186A-C may be arranged with and operable to control the flow of the cooling fluid through a respective one of the subcircuits 170A-C and its circuit passages 172A-C. Each fluid pump 186 of FIG. 11, for example, is fluidly coupled between the inlet into the respective subcircuit 170 and the circuit passages 172. Each fluid pump 186 may also be external to and/or mounted to the cooling plate 128. Each fluid pump 186 of FIG. 11, for example, is mounted to one of the plate sides (e.g., 140). With this arrangement, a section of each subcircuit 170 may be disposed outside of the cooling plate 128, within the respective fluid pump 186.

Each fluid pump 186 of FIG. 12 is in signal communication with a pump controller 188. This pump controller 188 may be discrete from the EM controllers 98 and/or the cooling system pump controller 138 (see FIG. 3). The pump controller 188, for example, may be part of the onboard engine controller. Alternatively, the pump controller 188 may also be discrete from the onboard engine controller. Still alternatively, the pump controller 188 may be integrated into the controller circuitry 112 (see FIG. 2) of one, some or all of the EM controllers 98 such that each EM controller 98 may control operation of a respective one of the fluid pumps 186. Or, the pump controller 188 may be integrated into circuitry of the cooling system pump controller 138 (see FIG. 3) such that the cooling system pump controller 138 may control operation of the fluid pumps 186 in addition to the cooling system fluid pump 126.

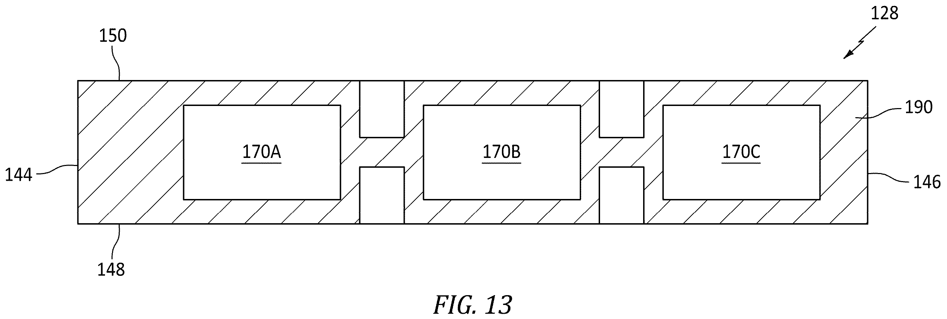

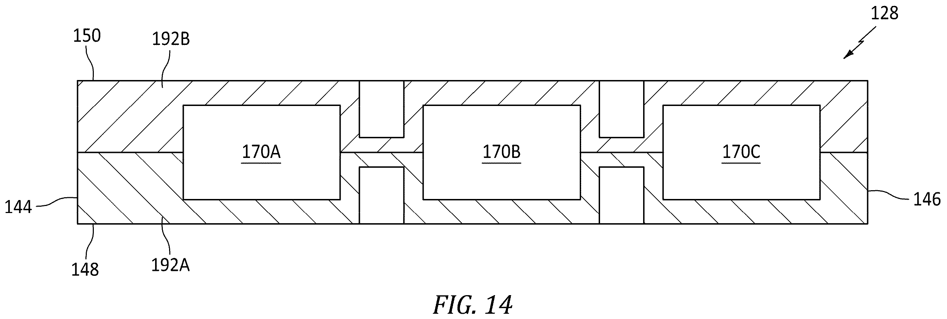

In some embodiments, referring to FIG. 13, the cooling plate 128 may be configured as a monolithic body 190. The cooling plate 128, for example, may be cast, machined, additively manufactured and/or otherwise formed as a single unitary body. In other embodiments, referring to FIG. 14, the cooling plate 128 may alternatively be configured as a non-monolithic body. The cooling plate 128 of FIG. 14, for example, includes multiple sections 192A and 192B (e.g., halves) which are discretely formed and subsequently mated and mechanically fastened, bonded (e.g., welded, brazed, etc.) and/or otherwise joined together to form the cooling plate 128.

While the cooling plate 128 of FIG. 5 and its associated components are described above as being disposed within the outer housing compartment 80 (see also FIG. 1), the present disclosure is not limited to such an exemplary arrangement. For example, the cooling plate 128 and its associated components may alternatively be disposed within another compartment within the aircraft propulsion system 22, a compartment within a pylon structure for the aircraft propulsion system 22, or the like. For example, where the aircraft propulsion system 22 is an open rotor propulsion system without an outer case as shown in FIG. 1, the cooling plate 128 and the associated components may be disposed within the inner housing compartment 72.

While various embodiments of the present disclosure have been described, it will be apparent to those of ordinary skill in the art that many more embodiments and implementations are possible within the scope of the disclosure. For example, the present disclosure as described herein includes several aspects and embodiments that include particular features. Although these features may be described individually, it is within the scope of the present disclosure that some or all of these features may be combined with any one of the aspects and remain within the scope of the disclosure. Accordingly, the present disclosure is not to be restricted except in light of the attached claims and their equivalents.

## Claims

1. An assembly for an aircraft powerplant, comprising:
a cooling plate including a fluid cooling circuit, a cooling circuit inlet and a cooling circuit outlet, the fluid cooling circuit extending within the cooling plate from the cooling circuit inlet to the cooling circuit outlet;
a first electric machine controller including a first controller housing and first controller circuitry, the first controller housing removably attached to the cooling plate and overlapping the fluid cooling circuit, the first controller circuitry disposed within an interior of the first controller housing, and the first controller circuitry in thermal communication with the cooling plate through a wall of the first controller housing; and
a second electric machine controller including a second controller housing and second controller circuitry, the second controller housing removably attached to the cooling plate and overlapping the fluid cooling circuit, the second controller circuitry disposed within an interior of the second controller housing, and the second controller circuitry in thermal communication with the cooling plate through a wall of the second controller housing.

2. The assembly of claim 1, wherein the fluid cooling circuit is internal to the cooling plate.

3. The assembly of claim 1 or 2, wherein the fluid cooling circuit is discrete from and fluidly decoupled from the first electric machine controller and the second electric machine controller.

4. The assembly of claim 1, 2 or 3, further comprising:
a cooling system including the cooling plate, a heat exchanger and a cooling loop;
the cooling loop including and extending through the fluid cooling circuit and one or more passages within the heat exchanger; and
the cooling system configured to circulate a cooling fluid through the cooling loop between the cooling plate and the heat exchanger.

5. The assembly of claim 4, wherein the cooling system further includes a reservoir fluidly coupled along the cooling loop between an outlet from the one or more passages within the heat exchanger and the cooling circuit inlet; and/or
wherein the cooling system further includes a pump fluidly coupled along the cooling loop between an outlet from the one or more passages within the heat exchanger and the cooling circuit inlet.

6. The assembly of any preceding claim, wherein
the fluid cooling circuit includes a first circuit passage and a second circuit passage;
the first circuit passage and the second circuit passage are arranged in parallel between the cooling circuit inlet and the cooling circuit outlet;
the first controller housing overlaps the first circuit passage; and
the second controller housing overlaps the second circuit passage.

7. The assembly of any of claims 1 to 5, wherein
the fluid cooling circuit includes a first circuit passage and a second circuit passage;
the first circuit passage and the second circuit passage are arranged in series between the cooling circuit inlet and the cooling circuit outlet;
the first controller housing overlaps the first circuit passage; and
the second controller housing overlaps the second circuit passage.

8. The assembly of claim 7, wherein the fluid cooling circuit further includes a plurality of crossover passages fluidly coupled with and in parallel between the first circuit passage and the second circuit passage.

9. The assembly of any preceding claim, wherein the cooling circuit inlet and the cooling circuit outlet are located on different sides of the cooling plate, or
wherein the cooling circuit inlet and the cooling circuit outlet are located on a common side of the cooling plate.

10. The assembly of any preceding claim, wherein
the cooling plate further includes a second fluid cooling circuit, a second cooling circuit inlet and a second cooling circuit outlet; and
the second fluid cooling circuit is discrete from the fluid cooling circuit within the cooling plate, and the second fluid cooling circuit extends within the cooling plate from the second cooling circuit inlet to the second cooling circuit outlet.

11. The assembly of any preceding claim, wherein
the cooling plate extends circumferentially around an axis between a first circumferential side of the cooling plate and a second circumferential side of the cooling plate, the cooling plate extends radially between an inner side of the cooling plate and an outer side of the cooling plate, and the cooling plate includes a first planar surface and a second planar surface at the outer side of the cooling plate;
the first controller housing radially contacts and is removably attached to the first planar surface; and
the second controller housing radially contacts and is removably attached to the second planar surface; and/or
wherein the first controller housing contacts and is thermally coupled to the cooling plate through a meshed interface between the first controller housing and the cooling plate; and
the second controller housing contacts and is thermally coupled to the cooling plate through a meshed interface between the second controller housing and the cooling plate.

12. The assembly of any preceding claim, wherein the cooling plate is configured as a monolithic body; and/or
further comprising:
a fan rotor; and
a fan case housing the fan rotor;
the cooling plate flexibly mounted to the fan case with an air gap formed by and extending radially between the fan case and the cooling plate.

13. The assembly of any preceding claim, further comprising:
an electrical system;
a first electric machine electrically coupled to the electrical system through the first electric machine controller, the first controller circuitry configured to control a first flow of electricity between the electrical system and the first electric machine; and
a second electric machine electrically coupled to the electrical system through the second electric machine controller, the second controller circuitry configured to control a second flow of electricity between the electrical system and the second electric machine; and/or
further comprising:
an engine core including a flowpath, a compressor section, a combustor section, a turbine section, a first rotating assembly and a second rotating assembly, the flowpath extending through the compressor section, the combustor section and the turbine section, the first rotating assembly comprising a first bladed rotor disposed in the compressor section or the turbine section, and the second rotating assembly comprising a second bladed rotor disposed in the compressor section or the turbine section;
a first electric machine electrically coupled to the first electric machine controller, the first electric machine comprising a first electric machine rotor operatively coupled to and rotatable with the first rotating assembly; and
a second electric machine electrically coupled to the second electric machine controller, the second electric machine comprising a second electric machine rotor operatively coupled to and rotatable with the second rotating assembly.

14. An assembly for an aircraft powerplant, comprising:
a cooling plate including a fluid cooling circuit, a cooling circuit inlet and a cooling circuit outlet, the fluid cooling circuit extending within the cooling plate from the cooling circuit inlet to the cooling circuit outlet;
a first electric machine controller removably attached to the cooling plate and overlapping the fluid cooling circuit, the first electric machine controller in thermal communication with the cooling plate through an interface between the first electric machine controller and the cooling plate;
a second electric machine controller removably attached to the cooling plate and overlapping the fluid cooling circuit, the second electric machine controller in thermal communication with the cooling plate through an interface between the second electric machine controller and the cooling plate;
an electrical system;
a first electric machine electrically coupled to the electrical system through the first electric machine controller; and
a second electric machine electrically coupled to the electrical system through the second electric machine controller.

15. An assembly for an aircraft powerplant, comprising:
a cooling plate including a fluid cooling circuit, a cooling circuit inlet and a cooling circuit outlet, the fluid cooling circuit extending within the cooling plate from the cooling circuit inlet to the cooling circuit outlet, the cooling plate extending circumferentially around an axis between a first circumferential side of the cooling plate and a second circumferential side of the cooling plate, the cooling plate extending radially between an inner side of the cooling plate and an outer side of the cooling plate, and the cooling plate including a first planar surface and a second planar surface at the outer side of the cooling plate;
a first electric machine controller removably attached to the cooling plate and overlapping the fluid cooling circuit, the first electric machine controller radially contacting the first planar surface; and
a second electric machine controller removably attached to the cooling plate and overlapping the fluid cooling circuit, the second electric machine controller radially contacting the second planar surface.
